# EUROPEAN PATENT SPECIFICATION

(11) **EP 2 204 399 B1**
(45) Date of publication and mention of the grant of the patent: **31.08.2016**
(21) Application number: 09180744.6
(22) Date of filing: 24.12.2009
(51) Int. Cl.: C08G 77/50, C08G 77/52, C08L 83/04, C08L 83/14, C09D 183/04, C09D 183/14, C08K 5/09, C08K 5/19, C08K 5/42, G03F 7/11, H01L 21/027, H01L 21/312

(54) **RESIST UNDERLAYER COMPOSITION AND METHOD OF MANUFACTURING SEMICONDUCTOR INTEGRATED CIRCUIT DEVICE USING THE SAME**
Harzunterschichtzusammensetzung und Verfahren zur Herstellung einer integrierten Halbleiterschaltungsvorrichtung damit
Composition de sous-couche de réserve et procédé de fabrication d'un dispositif à circuit intégré semi-conducteur l'utilisant

(30) Priority: 30.12.2008 KR 20080137227
(43) Date of publication of application: 07.07.2010
(73) Proprietor: CHEIL INDUSTRIES INC., Kumi-city, Kyungsangbuk-do (KR)
(72) Inventor: Cho, Hyeon-Mo, Uiwang-si Gyeonggi-do 437 711 (KR); Kim, Sang-Kyun, Uiwang-si (KR); Woo, Chang-Soo, Uiwang-si Gyeonggi-do 437 711 (KR); Kim, Mi-Young, Uiwang-si (KR); Koh, Sang-Ran, Uiwang-si (KR); Yun, Hiu-Chan, Uiwang-si (KR); Lee, Woo-Jin, Uiwang-si (KR); Kim, Jong-Seob, Uiwang-si (KR)
(74) Representative: Michalski Hüttermann & Partner Patentanwälte mbB

(56) References cited:
- WO-A1-2007/105859
- WO-A1-2008/018664
- JP-A- 4 233 544
- US-A- 3 017 386
- US-A- 3 234 179
- US-A- 5 321 102
- US-A1- 2002 086 169
- US-A1- 2003 130 389
- US-A1- 2008 118 875

## Description

### BACKGROUND

### (a) Field of the Invention

The present invention relates to a resist underlayer composition that is capable of adjusting a refractive index and absorbance to provide a resist underlayer having excellent anti-reflective characteristics, and a method of manufacturing a semiconductor integrated circuit device.

### (b) Description of the Related Art

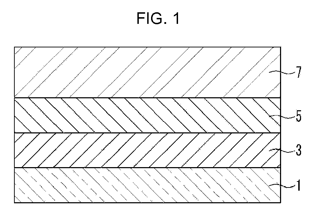

Generally, most lithography processes minimizes reflection between a resist layer and a substrate in order to increase a resolution. For this reason, an anti-reflective coating (ARC) is used between the resist layer and the substrate to improve the resolution. However, since the anti-reflective coating material is similar to a resist material in terms of basic composition, there is a drawback in that the anti-reflective coating material has a poor etch selectivity with respect to a resist layer with an image imprinted therein. Therefore, it is required to additionally perform a lithography process in a subsequent etching process. Also, general resist materials do not have sufficient resistance to the subsequent etching process. When a resist layer is thin, when a substrate to be etched is thick, when an etch depth is required to be deep, or when a particular echant is required for a particular substrate, a resist underlayer has been widely used. The resist underlayer includes two layers having an excellent etch selectivity. Referring to FIG. 1, a first resist underlayer 3, which is generally formed of an organic material, is formed on a substrate 1, which is formed of a silicon oxide layer, and a second resist underlayer 5 is formed on the first resist underlayer 3. Lastly, a resist layer 7 is formed on the second resist underlayer 5. Since the second resist underlayer 5 has a higher etch selectivity with respect to the resist layer 7 than the substrate 1, a pattern may be easily transferred even when a thin resist layer 7 is used. The first resist underlayer 3 is etched and the pattern is transferred by using the second resist underlayer 5 with a pattern transferred thereto as a mask, and then the pattern is transferred to the substrate 1 by using the first resist underlayer 3 as a mask. To sum up, a substrate is etched to a desired depth by using a thinner resist layer 7. Also, the second resist underlayer is a layer formed under the resist layer while functioning as an anti-reflective coating material. The second resist underlayer is required to have such an optical characteristic that it absorbs light emitted from an exposer and does not reflect the light. Particularly, as semiconductor devices are miniaturized to have a line width of tens of nanometers, semiconductor fabrication processes requires a delicate control of the optical characteristics. In order to realize a high-resolution resist pattern, it is required to control the refractive index and absorbance of the second resist underlayer 5. Generally, a phenyl group, which is a simple light absorbing material, has been used to increase the absorbance. However, as the content of the phenyl group becomes higher, the refractive index increases as well. Therefore, it is difficult to decrease the refractive index. Therefore, it is required to develop a light absorbing material that may facilitate controlling the refractive index and absorbance.

The US 2008/118875, JP 04233544 and US 2003/130389 A1 discloses a hardmask compositions with organosilicon polymers. A method of making organosilicon polymers is disclosed in the US 3,234,179.

is not limited thereto but rather is defined by scope of the appended claims. As used herein, when specific definition is not otherwise provided, the term "substituted" refers to one substituted with a C1 to C6 alkyl group, that can be preferably a C2 to C5 alkyl group, further preferred a C3 to C4 alkyl group or a C6 to C12 aryl group, that can be preferably a C7 to C11 aryl group, further preferred a C8 to C10 aryl group or a C9 aryl group. As used herein, when specific definition is not otherwise provided, the term "alkoxy" refers to -OR; and the term "ester" refers to -COOR, where R is a C1 to C6 alkyl group, that can be preferably C2 to C5 alkyl group, further preferred C3 to C4 alkyl group or a C6 to C12 aryl group, that can be preferably C7 to C11 aryl group, further preferred C8 to C10 aryl group or C9 aryl group. As used herein, when specific definition is not otherwise provided, the term "alkyl" refers to a C1 to C6 alkyl, preferably to a C2 to C5 alkyl group, further preferred to a C3 to C4 alkyl group; the term "alkylene" refers to C1 to C6 alkylene, preferably C2 to C5 alkylene group, further preferred C3 to C4 alkylene group; the term "an aryl" refers to a C6 to C12 aryl, preferably to a C7 to C11 aryl group, further preferred to a C8 to C10 aryl group or to a C9 aryl group; the term "arylene" refers to a C6 to C12 arylene, preferably to a C7 to C11 arylene group, further preferred to a C8 to C10 arylene group or to a C9 arylene group; the term "alkenyl" refers to a C2 to C6 alkenyl, preferably to a C2 to C5 alkenyl group, further preferred to a C3 to C4 alkenyl group; the term "alkenylene" refers to a C2 to C6 alkenylene, preferably to a C2 to C5 alkenylene group, further preferred to a C3 to C4 alkenylene group; the term "alkynyl" refers to a C2 to C6 alkynyl, preferably to a C2 to C5 alkynyl group, further preferred to a C3 to C4 alkynyl group; and the term "alkynylene" refers to a C2 to C6 alkynylene, preferably to a C2 to C5 alkynylene group, further preferred to a C3 to C4 alkynylene group. As used herein, when specific definition is not otherwise provided, the term "heterocyclic group" refers to: - a C3 to C12 heteroarylene group, preferably to a C4 to C10 heteroarylene group, further preferred to a C5 to C9 heteroarylene group, furthermore preferred to a C6 to C8 heteroarylene group,

### SUMMARY

One aspect of this disclosure provides a resist underlayer composition being capable of easily adjusting a refractive index and absorbance.

Another aspect of this disclosure provides a resist underlayer having excellent anti-reflective characteristics.

Further aspect of this disclosure provides a method of manufacturing a semiconductor integrated circuit device using the resist underlayer composition is provided.

According to the present invention, a resist underlayer composition is provided that comprises
(i) an organosilane condensation polymerization product obtained from at least one of the compounds of the Chemical Formula 1 and 2, and the compounds of the Chemical Formula 3 and 4, wherein the organosilane condensation polymerization product further includes a compound of the Chemical Formula 5; or
(ii) an organosilane condensation polymerization product including a repeating unit represented by the Chemical Formula 6; and
a solvent:

[Chemical Formula 1] [R¹]₃Si-[Ph¹]ₗ-Si[R²]₃

[Chemical Formula 2] [R¹]₃Si-[Ph¹]ₘ-Ph²

[Chemical Formula 3] [R¹]₃Si- (CH₂)ₙ-R³

[Chemical Formula 4] [R¹]₃Si-R⁴

[Chemical Formula 5] [R¹]₃Si-X-Si[R²]₃

[Chemical Formula 6] (SiO_{1.5}-[Ph¹]ₗ-SiO_{1.5})ₐ (Ph²-[Ph¹]ₘ-SiO_{1.5})_{b} (R³- CH₂ₙ-SiO_{1.5})_{c}(R⁴-SiO_{1.5})_{d}(SiO_{1.5}-X-SiO_{1.5})ₑ,

wherein 0≤a≤0.99, 0≤b≤0.99, 0.01≤a+b≤0.99, and 0≤c≤0.99, 0≤d≤0.99, 0<e≤0.99, 0.01≤c+d+e≤0.99, a+b+c+d+e=1;
wherein in the Chemical Formula 1 to 6,
Ph¹ is a substituted or unsubstituted phenylene group,
Ph² is a substituted or unsubstituted phenyl group,
R¹ and R² are the same or different, a halogen, a hydroxyl group, an alkoxy group, an ester group, a cyano group, a haloalkylsulfite group, an alkylamine group, an alkylsilylamine group, or an alkylsilyloxy group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group, or an urea group,
in its main chain, m is an integer ranging from 1 to 4, or 2 to 3, I is an integer ranging from 2 to 4, or 2 to 3 and n is 0 or an integer ranging from 1 to 5, 2 to 4 or 3.

According to a preferred embodiment of the present invention, a resist underlayer composition is provided that includes an organosilane condensation polymerization product obtained from at least one of the compounds of the following Chemical Formula 1 and 2, and the compounds of the Chemical

Formula 3 and 4, wherein the organosilane condensation polymerization product further includes a compound of the Chemical Formula 5; and a solvent.

[Chemical Formula 1] [R¹]₃Si-[Ph¹]ₗ-Si[R²]₃

[Chemical Formula 2] [R¹]₃Si-[Ph¹]ₘ-Ph²

[Chemical Formula 3] [R¹]₃Si- (CH2)n-R3

[Chemical Formula 4] [R¹]₃Si-R⁴

[Chemical Formula 5] [R¹]₃Si-X-Si[R²]₃

In the above Chemical Formula 1 to 5,
Ph¹ is a substituted or unsubstituted phenylene group,
Ph² is a substituted or unsubstituted phenyl group,
R¹ and R² are the same or different, and independently, a halogen, a hydroxyl group, an alkoxy group,
an ester group, a cyano group, a halogenoalkylsulfite group, an alkylamine group, an alkylsilylamine group, or an alkylsilyloxy group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group, or an urea group, in its main chain,
m is an integer ranging from 1 to 4, or 2 to 3, I is an integer ranging from 2 to 4, or 2 to 3 and
n is 0 or an integer ranging from 1 to 5, 2 to 4 or 3.

According to another preferred embodiment of the present invention, a resist underlayer composition is provided that includes an organosilane condensation polymerization product including a repeating unit represented by the following Chemical Formula 6; and a solvent.

[Chemical Formula 6] (SiO_{1.5}-[Ph¹]ₗ-SiO_{1.5})ₐ(Ph²-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ

In the Chemical Formula 6,
Ph¹ is a substituted or unsubstituted phenylene group,
Ph² is a substituted or unsubstituted phenyl group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group or an urea group, in its main chain,
m is an integer ranging from 1 to 4, or 2 to 3, I is an integer ranging from 2 to 4, or 2 to 3
n is 0 or an integer ranging from 1 to 5, 2 to 4 or 3,
0≤a≤0.99, 0≤b≤0.99, 0.01≤a+b≤0.99, and
0≤c≤0.99, 0≤d≤0.99, 0<e≤0.99,
0.01≤c+d+e≤0.99, a+b+c+d+e=1.

According to further aspect of this disclosure, a resist underlayer including an organosilane condensation polymerization product including the repeating unit represented by the following Chemical Formula 6 is provided.

[Chemical Formula 6] (SiO_{1.5}-[Ph¹]ₗ-SiO_{1.5})ₐ(Ph²-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ

In the above Chemical Formula 6,
Ph¹ is a substituted or unsubstituted phenylene group,
Ph² is a substituted or unsubstituted phenyl group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group or an urea group, in its main chain,
m is an integer ranging from 1 to 4, l is an integer ranging from 2 to 4,
n is 0 or an integer ranging from 1 to 5, 0≤a≤0.99, 0≤b≤0.99, 0.01≤a+b≤0.99, and
0≤c≤0.99, 0≤d≤0.99, 0<e≤0.99, 0.01≤c+d+e≤0.99, a+b+c+d+e=1.

According to a further aspect of this disclosure, a method of manufacturing a semiconductor integrated circuit device is provided that includes (a) providing a material layer on a substrate; (b) forming a first resist underlayer on the material layer; (c) coating the resist underlayer composition on the first resist underlayer to form a second resist underlayer; (d) forming a radiation-sensitive imaging layer on the second underlayer; (e) pattern wise exposing the radiation-sensitive imaging layer to radiation to form a pattern of radiation-exposed regions in the imaging layer; (f) selectively removing portions of the radiation-sensitive imaging layer and the second resist underlayer to expose portions of the first resist underlayer; (g) selectively removing patterned second resist underlayer and portions of the first resist underlayer to expose portions of the material layer; and (h) etching the exposed portions of the material layer to pattern the material layer.

Hereinafter, further embodiments of this disclosure will be described in detail.

According to one embodiment, a resist underlayer composition may provide a resist underlayer having excellent anti-reflective characteristics capable of easily controlling a refractive index and an absorbance within a wavelength range of lower than about 250 nm. Therefore, it is possible to effectively provide a semiconductor integrated circuit device with fine patterns.

### BRIEF DESCRIPTION OF THE DRAWING

FIG. 1 is a cross-sectional view of a multi-layer formed by sequentially stacking a first resist underlayer, a second resist underlayer, and a resist layer on a substrate.

### DETAILED DESCRIPTION

Exemplary embodiments of the present invention will hereinafter be described in detail. However, these embodiments are only exemplary, and the present invention is not limited thereto but rather is defined by scope of the appended claims.

As used herein, when specific definition is not otherwise provided, the term "substituted" refers to one substituted with a C1 to C6 alkyl group, that can be preferably a C2 to C5 alkyl group, further preferred a C3 to C4 alkyl group or a C6 to C12 aryl group, that can be preferably a C7 to C11 aryl group, further preferred a C8 to C10 aryl group or a C9 aryl group.

As used herein, when specific definition is not otherwise provided, the term "alkoxy" refers to -OR; and the term "ester" refers to -COOR, where R is a C1 to C6 alkyl group, that can be preferably C2 to C5 alkyl group, further preferred C3 to C4 alkyl group or a C6 to C12 aryl group, that can be preferably C7 to C11 aryl group, further preferred C8 to C10 aryl group or C9 aryl group.

As used herein, when specific definition is not otherwise provided, the term "alkyl" refers to a C1 to C6 alkyl, preferably to a C2 to C5 alkyl group, further preferred to a C3 to C4 alkyl group; the term "alkylene" refers to C1 to C6 alkylene, preferably C2 to C5 alkylene group, further preferred C3 to C4 alkylene group; the term "an aryl" refers to a C6 to C12 aryl, preferably to a C7 to C11 aryl group, further preferred to a C8 to C10 aryl group or to a C9 aryl group; the term "arylene" refers to a C6 to C12 arylene, preferably to a C7 to C11 arylene group, further preferred to a C8 to C10 arylene group or to a C9 arylene group; the term "alkenyl" refers to a C2 to C6 alkenyl, preferably to a C2 to C5 alkenyl group, further preferred to a C3 to C4 alkenyl group; the term "alkenylene" refers to a C2 to C6 alkenylene, preferably to a C2 to C5 alkenylene group, further preferred to a C3 to C4 alkenylene group; the term "alkynyl" refers to a C2 to C6 alkynyl, preferably to a C2 to C5 alkynyl group, further preferred to a C3 to C4 alkynyl group; and the term "alkynylene" refers to a C2 to C6 alkynylene, preferably to a C2 to C5 alkynylene group, further preferred to a C3 to C4 alkynylene group.

As used herein, when specific definition is not otherwise provided, the term "heterocyclic group" refers to:
- a C3 to C12 heteroarylene group, preferably to a C4 to C10 heteroarylene group, further preferred to a C5 to C9 heteroarylene group, furthermore preferred to a C6 to C8 heteroarylene group,
- a C1 to C12 heterocycloalkylene group, preferably to a C2 to C11 heterocycloalkylene group, also preferred to a C3 to C10 heterocycloalkylene group, further preferred to a C5 to C9 heterocycloalkylene group, furthermore preferred to a C6 to C8 heterocycloalkylene group,
- a C1 to C12 heterocycloalkenylene group, preferably to a C2 to C11 heterocycloalkenylene group, also preferred to a C3 to C10 heterocycloalkenylene group, further preferred to a C5 to C9 heterocycloalkenylene group, furthermore preferred to a C6 to C8 heterocycloalkenylene group,
- a C1 to C12 heterocycloalkynylene group, preferably to a C2 to C11 heterocycloalkynylene group, also preferred to a C3 to C10 heterocycloalkynylene group, further preferred to a C5 to C9 heterocycloalkynylene group, furthermore preferred to a C6 to C8 heterocycloalkynylene group, or
- a fused ring thereof,
and includes a heteroatom of N, O, S, or P in a ring.
The heterocyclic group includes 1 to 5, 2 to 4 or 3 hetero atoms.

The resist underlayer composition according to one embodiment includes an organosilane condensation polymerization product and a solvent.

The organosilane condensation polymerization product can be preferably obtained from at least one of the compounds of the following Chemical Formula 1 to 2, and the compounds of the Chemical Formula 3 and 4, wherein the organosilane condensation polymerization product further includes a compound of the Chemical Formula 5.

[Chemical Formula 1] [R¹]₃Si-[Ph¹]ₗ-Si[R²]₃

[Chemical Formula 2] [R¹]₃Si-[Ph¹]ₘ-Ph²

[Chemical Formula 3] [R¹]₃Si- (CH₂)ₙ-R³

[Chemical Formula 4] [R¹]₃Si-R⁴

[Chemical Formula 5] [R¹]₃Si-X-Si[R²]₃

In the above Chemical Formula 1 to 5,
Ph¹ is a substituted or unsubstituted phenylene group,
Ph² is a substituted or unsubstituted phenyl group,
R¹ and R² are the same or different, and independently, a halogen, a hydroxyl group, an alkoxy group, an ester group, a cyano group, a haloalkylsulfite group, an alkylamine group, an alkylsilylamine group, or an alkylsilyloxy group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group or an urea group, in its main chain,
m is an integer ranging from 1 to 4, l is an integer ranging from 2 to 4, preferably 2 to 3 and
n is 0 or an integer ranging from 1 to 5, 2 to 4 or 3.

In one embodiment, the organosilane condensation polymerization product may be ≥ 1 to ≤ 99 mol%, ≥ 2 to ≤ 98 mol%, ≥ 5 to ≤ 95 mol%, ≥ 10 to ≤ 90 mol%, ≥ 20 to ≤ 80 mol%, ≥ 30 to ≤ 70 mol%, ≥ 40 to ≤ 60 mol% or ≥ 50 mol% of at least one compound selected from the group consisting of the compounds represented by Chemical Formula 1 to 2; and an organosilane condensation polymerization product produced based on a hydrolysis and/or a condensation polymerization reaction under the presence of an acid catalyst or a base catalyst from ≥ 1 to ≤ 99 mol%, ≥ 2 to ≤ 98 mol%, ≥ 5 to ≤ 95 mol%, ≥ 10 to ≤ 90 mol%, ≥ 20 to ≤ 80 mol%, ≥ 30 to ≤ 70 mol%, ≥ 40 to ≤ 60 mol% or ≥ 50 mol% of at least one compound selected from the group consisting of the compounds represented by Chemical Formula 3 to 5, provided that a compound of Chemical Formula 5 is included. In one embodiment, the at least one compound selected from the group consisting of the compounds represented by Chemical Formula 1 to 2 may be used in a concentration of ≥ 1 to ≤ 50 mol%, %, ≥ 2 to ≤ 45 mol%, ≥ 5 to ≤ 40 mol%, ≥ 10 to ≤ 35 mol%, ≥ 15 to ≤ 30 mol%, ≥ 20 to ≤ 25 mol%, and the at least one compound selected from the compounds represented by Chemical Formula 3 to 5 may be used in a concentration of ≥ 50 to ≤ 99 mol%,≥ 52 to ≤ 98 mol%, ≥ 55 to ≤ 95 mol%, ≥ 60 to ≤ 90 mol%, ≥ 65 to ≤ 85 mol%, ≥ 70 to ≤ 80 mol%, to acquire a desired optical characteristics controlling effect.

The organosilane condensation polymerization product may have a weight average molecular weight of about 2,000 to about 50,000. In one embodiment, the organosilane condensation polymerization product may have a weight average molecular weight of about 3,000 to about 20,000 in consideration of a coating performance on a substrate and to prevent generation of gel.

Also, the organosilane condensation polymerization product may be included in an amount of ≥ 0.1 wt% to ≤ 50 wt%, ≥ 0.2 wt% to ≤ 45 wt%, ≥ 0.5 wt% to ≤ 40 wt%, ≥ 1 wt% to ≤ 35 wt%, ≥ 5 wt% to ≤ 30 wt%, ≥ 10 wt% to ≤ 20 wt %, based on 100 wt% of the entire resist underlayer composition.

In one embodiment, the organosilane condensation polymerization product may be preferably included in an amount of ≥ 1 wt% to ≤ 30 wt%, ≥ 2 wt% to ≤ 25 wt%, ≥ 5 wt% to ≤ 20 wt %, ≥ 10 wt% to ≤ 15 wt %, in consideration of a coating performance on a substrate.

The acid catalyst or base catalyst facilitates the acquisition of the organosilane condensation polymerization product having a desired molecular weight by properly controlling the speed of a hydrolysis reaction or a condensation polymerization reaction of the above Chemical Formula. The kinds of the acid catalyst and the base catalyst are not limited to specific ones but what is generally used in the art to which this disclosure pertains may be used. In one embodiment, the acid catalyst may be selected from the group consisting of hydrofluoric acid, hydrochloric acid, bromic acid, iodic acid, nitric acid, sulfuric acid, p-toluenesulfonic acid monohydrate, diethylsulfate, 2,4,4,6-tetrabromocyclohexadienone, benzoin tosylate, 2-nitrobenzyl tosylate, alkyl esters of organic sulfonic acids, and a combination thereof. Also, the base catalyst may be selected from the group consisting of an alkylamine such as triethylamine and diethylamine, ammonia, sodium hydroxide, potassium hydroxide, pyridine, and a combination thereof. Herein, the acid catalyst or the base catalyst may be used in an amount of about 0.001 to about 5 parts by weight based on 100 parts by weight of the entire compound producing the organosilane condensation polymerization product in order to acquire a condensation polymerization product of a desired molecular weight by properly controlling a reaction speed.

Also, in the resist underlayer composition according to one embodiment, the solvent prevent void, and dries a film slowly to thereby improve planar property. The kind of the solvent is not limited to specific ones but what is generally used as the solvent may be the solvent. In one embodiment, a solvent having a high boiling point that volatilize at a temperature slightly lower than a temperature where the resist underlayer composition according to one embodiment is coating, dried, and solidified. Examples of the solvent include toluene, propylene glycol methyl ether, propylene glycol ethyl ether, propylene glycol propyl ether, propylene glycol methyl ether acetate, propylene glycol ethyl ether acetate, propylene glycol propyl ether acetate, ethyl lactate, g-butyrolactone, methyl isobutyl ketone, or a combination thereof.

The resist underlayer composition may further include an additive selected from the group consisting of a cross-linking agent, a radical stabilizer, a surfactant and a combination thereof.

The resist underlayer composition further includes a cross-linking catalyst of pyridinium p-toluenesulfonate, amidosulfobetain-16, ammonium(-)-camphor-10-sulfonic acid ammonium salt, ammonium formate, alkyltriethylammonium formate, pyridinium formate, tetrabutyl ammonium acetate, tetrabutyl ammonium azide, tetrabutyl ammonium benzoate, tetrabutyl ammonium bisulfate, tetrabutyl ammonium bromide, tetrabutyl ammonium chloride, tetrabutyl ammonium cyanide, tetrabutyl ammonium fluoride, tetrabutyl ammonium iodide, tetrabutyl ammonium sulfate, tetrabutyl ammonium nitrate, tetrabutyl ammonium nitrite, tetrabutyl ammonium p-toluene sulfonate, tetrabutyl ammonium phosphate, and a combination thereof.

The cross-linking catalyst may be added alone or along with an additive selected from the group consisting of a cross-linking agent, a radical stabilizer, a surfactant and a combination thereof to a composition including an organosilane polymerization product and a solvent.

When the resist underlayer composition further includes the additive, the additive may be included in an amount of ≥ 0.0001 to ≤ 1 part, ≥ 0.0005 to ≤ 0.9 part, ≥ 0.001 to ≤ 0.7 part, ≥ 0.005 to ≤ 0.5 part, ≥ 0.01 to ≤ 0.3 part, ≥ 0.05 to ≤ 0.1 part, by weight based on 100 parts by weight of the organosilane condensation polymerization product and this is desirable in terms of storage stability.

The resist underlayer composition according to another embodiment includes an organosilane condensation polymerization product including a repeating unit represented by the following Chemical Formula 6; and a solvent.

[Chemical Formula 6] (SiO_{1.5}-[Ph¹]ₗ-SiO_{1.5})ₐ(Ph²-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ

In the above Chemical Formula 6,
Ph¹ is a substituted or unsubstituted phenylene group,
Ph² is a substituted or unsubstituted phenyl group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group or an urea group, in its main chain,
m is an integer ranging from 1 to 4, in its main ranging from 2 to 4,
n is 0 or an integer ranging from 1 to 5, 0≤a≤0.99, 0≤b≤0.99, 0.01≤a+b≤0.99, and
0≤c≤0.99, 0≤d≤0.99, 0<e≤0.99, 0.01≤c+d+e≤0.99, a+b+c+d+e=1.

The resist underlayer composition according to one embodiment easily controls the refractive index and absorbance within a wavelength range of lower than about 250 nm. Thus, the resist underlayer with excellent anti-reflective characteristics may be provided.

According to another embodiment, a resist underlayer including an organosilane condensation polymerization product including a repeating unit represented by the following Chemical Formula 6 is provided.

[Chemical Formula 6] (SiO_{1.5}-[Ph¹]ₗ-SiO_{1.5})ₐ(Ph²-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ

In the above Chemical Formula 6,
Ph¹ is a substituted or unsubstituted phenylene group,
Ph² is a substituted or unsubstituted phenyl group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group or an urea group, in its main chain,
m is an integer ranging from 1 to 4, or 2 to 3, l is an integer ranging from 2 to 4, or 2 to 3,
n is 0 or an integer ranging from 1 to 5, 2 to 4 or 3,
0≤a≤0.99, 0≤b≤0.99, 0.01≤a+b≤0.99, and
0≤c≤0.99, 0≤d≤0.99, 0<e≤0.99, 0.01≤c+d+e≤0.99, a+b+c+d+e=1.

Generally, when absorbance increases, refractive index increases simultaneously. However, when the resist underlayer composition according to one embodiment is used, it is possible to have a low refractive index under the condition of a high absorbance because the optical characteristics may be adjusted to a desired level by using the compounds represented by Chemical Formula 1 and/or Chemical Formula 2.

In one embodiment, the resist underlayer may have an absorbance of higher than about 0.15 when it has a refractive index of lower than about 1.70 under the wavelength condition of about 193 nm.

According to another embodiment of this disclosure, a method of manufacturing a semiconductor integrated circuit device is provided. The method includes (a) providing a material layer on a substrate; (b) forming a first resist underlayer on the material layer; (c) coating the resist underlayer composition on the first resist underlayer to form a second resist underlayer; (d) forming a radiation-sensitive imaging layer on the second underlayer; (e) patternwise exposing the radiation-sensitive imaging layer to radiation to form a pattern of radiation-exposed regions in the imaging layer; (f) selectively removing portions of the radiation-sensitive imaging layer and the second resist underlayer to expose portions of the first resist underlayer; (g) selectively removing patterned second resist underlayer and portions of the first resist underlayer to expose portions of the material layer; and (h) etching the exposed portions of the material layer to pattern the material layer

The method may further include forming an anti-reflection coating between the processes of forming the second resist underlayer (c) and forming a radiation-sensitive imaging layer.

The second resist underlayer may include an organosilane condensation polymerization product including a repeating unit represented by the following Chemical Formula 6.

[Chemical Formula 6] (SiO_{1.5}-[Ph¹]ₗ-SiO_{1.5})ₐ(Ph²-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ

In the above Chemical Formula 6,
Ph¹ is a substituted or unsubstituted phenylene group,
Ph² is a substituted or unsubstituted phenyl group,
R³ is a substituted or unsubstituted C6 to C12 aryl group, preferably a C7 to C11 aryl group, further preferred a C8 to C10 aryl group or a C9 aryl group
R⁴ is hydrogen or a C1 to C6 alkyl group, preferably a C2 to C5 alkyl group, further preferred a C3 to C4 alkyl group,
X is a linear or branched substituted or unsubstituted alkylene group; or an alkylene group including an alkenylene group, or an urea group, in its main chain,
m is an integer ranging from 1 to 4, or 2 to 3, l is an integer ranging from 2 to 4, or 2 to 3,
n is 0 or an integer ranging from 1 to 5, 2 to 4 or 3,
0≤a≤0.99, 0≤b≤0.99, 0.01≤a+b≤0.99, and
0≤c≤0.99, 0≤d≤0.99, 0<e≤0.99,
0.01≤c+d+e≤0.99, a+b+c+d+e=1.

A method of forming a patterned material layer can be carried out in accordance with the following procedure.

First, a material (e.g., aluminum or silicon nitride (SiN)) to be patterned is applied to a silicon substrate by any technique known in the art. The material may be an electrically conductive, semi-conductive, magnetic or insulating material.

A first resist underlayer including an organic material is provided on the patterned material. The first resist underlayer may include an organic material including carbon, hydrogen, oxygen, and the like at a thickness of about 200 Å to about 12000 Å. The first resist underlayer is not limited to the above, and is formed according to various thicknesses using various materials by a person skilled in this art.

Thereafter, the resist underlayer composition according to one embodiment is spin-coated to a thickness of about 100 Å to about 4000 Å and baked at about 100 °C to about 300°C for about 10 seconds to about 10 minutes to form a second resist underlayer. The thickness, baking temperature, and baking time are not limited the above, and is formed according to various thicknesses, baking temperature, and baking time by a person skilled in this art.

A radiation-sensitive imaging layer is formed on the second resist underlayer. Light exposure and development are performed to form a pattern on the imaging layer. The imaging layer and antireflective layer are selectively removed to expose portions of the material layer and dry etching is performed using an etching gas. Examples of the etching gas include CHF₃, CH₂F₂, CF₄, CH₄, N₂, O₂, Cl₂, BCl₃, or a mixed gas. After forming a patterned material layer, a remaining material may be removed using a generally-used photoresist stripper.

According to another embodiment, a semiconductor integrated circuit device using the method is provided. Particularly, the method of another embodiment may be applied to the areas like a patterned material layer structure such as metal wiring line, hole for contact or bias; an insulation section such as a multi-mask trench or shallow trench insulation; and a trench for a capacitor structure such as designing of an integrated circuit device. Also, the method may be applied formation of a patterned layer of oxide, nitride, polysilicon and chromium. Also, this disclosure is not limited to a specific lithographic method or a specific device structure.

The following examples illustrate this disclosure in more detail. However, it is understood that this disclosure is not limited by these examples.

A person having ordinary skills in this art can sufficiently understand parts of this disclosure that are not specifically described.

### Comparative Example 1

Methyltrimethoxysilane (MT) 630 g is put into a 3ℓ 4-neck flask including a mechanical agitator, a condenser, a dropping funnel, and a nitrogen gas introduction tube and dissolved in PGMEA 1600 g, and then 5000 ppm nitric acid aqueous solution 300 g is added thereto. Subsequently, the solution is reacted at about 90 °C for about a 1 week. After the reaction, organosilane condensation polymerization product A1 (weight average molecular weight= 8000, polydispersity (PD) = 3.8) is acquired.

PGMEA 100 g is poured into the acquired polymer 5 g to thereby prepare a diluted solution. Pyridinium p-toluenesulfonate 0.5 g is added to the diluted solution to thereby prepare a resist underlayer composition.

The resist underlayer composition is applied to a silicon wafer through a spin-coating method and the silicon wafer coated with resist underlayer composition is baked at a temperature of about 200 °C for about one minute to thereby form a resist underlayer having a thickness of about 1000 Å.

### Comparative Example 2

Methyltrimethoxysilane (MT) 621 g (99 mol%) and phenyltrimethoxysilane (PT) 9 g (1 mol%) are put into a 3ℓ 4-neck flask including a mechanical agitator, a condenser, a dropping funnel, and a nitrogen gas introduction tube and dissolved in PGMEA 1600 g, and then 1% nitric acid aqueous solution 300 g is added thereto. Subsequently, the solution is reacted at about 100 °C for about a week. After the reaction, organosilane condensation polymerization product A2 (weight average molecular weight= 9500, polydispersity (PD) = 4) is acquired.

Subsequent process except for the process of acquiring the organosilane condensation polymerization product is performed the same as Comparative Example 1.

### Comparative Example 3

Methyltrimethoxysilane (MT) 594 g (96 mol%) and phenyltrimethoxysilane 36 g (4 mol%) are put into a 3ℓ 4-neck flask including a mechanical agitator, a condenser, a dropping funnel, and a nitrogen gas introduction tube and dissolved in PGMEA 1600 g, and then 1% nitric acid aqueous solution 300 g is added thereto. Subsequently, the solution is reacted at about 100 °C for about a week. After the reaction, organosilane condensation polymerization product A3 (weight average molecular weight= 8000, polydispersity (PD) = 3.7) is acquired.

Subsequent process except for the process of acquiring the organosilane condensation polymerization product is performed the same as Comparative Example 1.

### Comparative Example 4

Methyltrimethoxysilane (MT) 568 g (93 mol%) and phenyltrimethoxysilane (PT) 62 g (7 mol%) are put into a 3ℓ 4-neck flask including a mechanical agitator, a condenser, a dropping funnel, and a nitrogen gas introduction tube and dissolved in PGMEA 1600 g, and then 1% nitric acid aqueous solution 300 g is added thereto. Subsequently, the solution is reacted at about 100 °C for about a week. After the reaction, organosilane condensation polymerization product A4 (weight average molecular weight= 7000, polydispersity (PD) = 3.5) is acquired.

Subsequent process except for the process of acquiring the organosilane condensation polymerization product is performed the same as Comparative Example 1.

### Comparative Example 5

Methyltrimethoxysilane (MT) 534 g (89 mol%) and phenyltrimethoxysilane (PT) 96 g (11 mol%) are put into a 3ℓ 4-neck flask including a mechanical agitator, a condenser, a dropping funnel, and a nitrogen gas introduction tube and dissolved in PGMEA 1600 g, and then 1% nitric acid aqueous solution 300 g is added thereto. Subsequently, the solution is reacted at about 100 °C for about a week. After the reaction, organosilane condensation polymerization product A5 (weight average molecular weight= 5500, polydispersity (PD) = 3.0) is acquired.

Subsequent process except for the process of acquiring the organosilane condensation polymerization product is performed the same as Comparative Example 1.

### Comparative Example 6

Methyltrimethoxysilane (MT) 501 g (85 mol%) and phenyltrimethoxysilane (PT) 129 g (15 mol%) are put into a 3ℓ 4-neck flask including a mechanical agitator, a condenser, a dropping funnel, and a nitrogen gas introduction tube and dissolved in PGMEA 1600 g, and then 1% nitric acid aqueous solution 300 g is added thereto. Subsequently, the solution is reacted at about 100 °C for about a week. After the reaction, organosilane condensation polymerization product A6 (weight average molecular weight= 6000, polydispersity (PD) = 3.1) is acquired.

Subsequent process except for the process of acquiring the organosilane condensation polymerization product is performed the same as Comparative Example 1.

### Comparative Example 7

Methyltrimethoxysilane (MT) 424 g (75 mol%) and phenyltrimethoxysilane (PT) 206 g (25 mol%) are put into a 3ℓ 4-neck flask including a mechanical agitator, a condenser, a dropping funnel, and a nitrogen gas introduction tube and dissolved in PGMEA 1600 g, and then 2% nitric acid aqueous solution 300 g is added thereto. Subsequently, the solution is reacted at about 100 °C for about a week. After the reaction, organosilane condensation polymerization product A7 (weight average molecular weight= 7500, polydispersity (PD) = 3.6) is acquired.

Subsequent process except for the process of acquiring the organosilane condensation polymerization product is performed the same as Comparative Example 1.

### Comparative Example 8

Phenyltrimethoxysilane (PT) 630 g is put into a 3ℓ 4-neck flask including a mechanical agitator, a condenser, a dropping funnel, and a nitrogen gas introduction tube and dissolved in PGMEA 1600 g, and then 3% nitric acid aqueous solution 300 g is added thereto. Subsequently, the solution is reacted at about 100 °C for about a week. After the reaction, organosilane condensation polymerization product A8 (weight average molecular weight= 3000, polydispersity (PD) = 3.0) is acquired.

Subsequent process except for the process of acquiring the organosilane condensation polymerization product is performed the same as Comparative Example 1.

### Example 1

Bis(triethoxysilyl)biphenyl (BBP) 122 g, bis(triethoxysilyl)ethane (BE) 451 g, phenyltrimethoxysilane 25 g and methyltrimethoxysilane 120 g are put into a 3ℓ 4-neck flask including a mechanical agitator, a condenser, a dropping funnel, and a nitrogen gas introduction tube and dissolved in PGMEA 1800 g, and then 5000 ppm nitric acid aqueous solution 200 g is added thereto. Subsequently, the solution is reacted at about 80 °C for about 3 days. After the reaction, organosilane condensation polymerization product B1 (weight average molecular weight= 7000, polydispersity (PD) = 3) is acquired.

Subsequent process except for the process of acquiring the organosilane condensation polymerization product is performed the same as Comparative Example 1.

### Example 2

Bistriethoxybiphenyl 217 g, bistriethoxysilylethane 403 g, phenyltrimethoxysilane 23 g and methyltrimethoxysilane 77 g are put into a 3ℓ 4-neck flask including a mechanical agitator, a condenser, a dropping funnel, and a nitrogen gas introduction tube and dissolved in PGMEA 1800 g, and then 5000 ppm nitric acid aqueous solution 250 g is added thereto. Subsequently, the solution is reacted at about 80 °C for about 5 days. After the reaction, organosilane condensation polymerization product B2 (weight average molecular weight= 9700, polydispersity (PD) = 4) is acquired.

Subsequent process except for the process of acquiring the organosilane condensation polymerization product is performed the same as Comparative Example 1.

### Example 3

Bistriethoxybiphenyl 176 g, bistriethoxysilylethane 326 g, phenyltrimethoxysilane 73 g and methyltrimethoxysilane 25 g are put into a 3ℓ 4-neck flask including a mechanical agitator, a condenser, a dropping funnel, and a nitrogen gas introduction tube and dissolved in PGMEA 1000 g, and then 2000 ppm nitric acid aqueous solution 130 g is added thereto. Subsequently, the solution is reacted at about 60 °C for about 3 days. After the reaction, organosilane condensation polymerization product B3 (weight average molecular weight= 7000, polydispersity (PD) = 3) is acquired.

Subsequent process except for the process of acquiring the organosilane condensation polymerization product is performed the same as Comparative Example 1.

### Example 4 (Reference)

Bistriethoxybiphenyl 92 g, phenyltrimethoxysilane 38 g and methyltrimethoxysilane 470 g are put into a 3ℓ 4-neck flask including a mechanical agitator, a condenser, a dropping funnel, and a nitrogen gas introduction tube and dissolved in PGMEA 1000 g, and then 5000 ppm nitric acid aqueous solution 200 g is added thereto. Subsequently, the solution is reacted at about 80 °C for about 5 days. After the reaction, organosilane condensation polymerization product B4 (weight average molecular weight= 8500, polydispersity (PD) = 3.7) is acquired.

Subsequent process except for the process of acquiring the organosilane condensation polymerization product is performed the same as Comparative Example 1.

### Example 5 (Reference)

Bistriethoxybiphenyl 39 g, phenyltrimethoxysilane 64 g and methyltrimethoxysilane 497 g are put into a 3ℓ 4-neck flask including a mechanical agitator, a condenser, a dropping funnel, and a nitrogen gas introduction tube and dissolved in PGMEA 1000 g, and then 5000 ppm nitric acid aqueous solution 200 g is added thereto. Subsequently, the solution is reacted at about 80 °C for about 4 days. After the reaction, organosilane condensation polymerization product B5 (weight average molecular weight= 8000, polydispersity (PD) = 3.4) is acquired.

Subsequent process except for the process of acquiring the organosilane condensation polymerization product is performed the same as Comparative Example 1.

### Example 6 (Reference)

Bistriethoxybiphenyl 75 g, phenyltrimethoxysilane 39 g and methyltrimethoxysilane 486 g are put into a 3ℓ 4-neck flask including a mechanical agitator, a condenser, a dropping funnel, and a nitrogen gas introduction tube and dissolved in PGMEA 1200 g, and then 5000 ppm nitric acid aqueous solution 180 g is added thereto. Subsequently, the solution is reacted at about 80 °C for about 4 days. After the reaction, organosilane condensation polymerization product B6 (weight average molecular weight= 8500, polydispersity (PD) = 3.6) is acquired.

Subsequent process except for the process of acquiring the organosilane condensation polymerization product is performed the same as Comparative Example 1.

### Experimental Example 1

The refractive index (n) and absorbance (k) of the resist underlayer according to Comparative Examples 1 to 8 and Examples 1 to 6 are measured using an ellipsometer (J. A. Woollam).

The results are shown in Table 1.

**Table 1**

| | MT (mol%) | PT (mol%) | condens ation polymeri zation product | weight average molecular weight | refractive index (193 nm) | absorbance (193 nm) |
|---|---|---|---|---|---|---|
| Comparative Example 1 | 100 | 0 | A1 | 8000 | 1.52 | 0.00 |
| Comparative Example 2 | 99 | 1 | A2 | 9500 | 1.55 | 0.02 |
| Comparative Example 3 | 96 | 4 | A3 | 8000 | 1.60 | 0.08 |
| Comparative Example 4 | 93 | 7 | A4 | 7000 | 1.65 | 0.15 |
| Comparative Example 5 | 89 | 11 | A5 | 5500 | 1.70 | 0.21 |
| Comparative Example 6 | 85 | 15 | A6 | 6000 | 1.73 | 0.26 |
| Comparative Example 7 | 75 | 25 | A7 | 7500 | 1.77 | 0.47 |
| Comparative Example 8 | 0 | 100 | A8 | 3000 | 1.86 | 1.00 |
| □ MT(methyltrimethoxysilane): methyltrimethoxysilane | | | | | | |
| □ PT(phenyltrimethoxysilane): phenyltrimethoxysilane | | | | | | |

**Table 2**

| | BBP (mol%) | MT (mol%) | PT (mol%) | BE (mol%) | condens ation polymeriz ation product | weight average molecular weight | refractive index (193 nm) | absorbance (193 nm) |
|---|---|---|---|---|---|---|---|---|
| Example 1 | 10 | 35 | 5 | 50 | B1 | 7000 | 1.60 | 0.17 |
| Example 2 | 20 | 25 | 5 | 50 | B2 | 9700 | 1.58 | 0.23 |
| Example 3 | 20 | 10 | 20 | 50 | B3 | 7000 | 1.67 | 0.35 |
| Example 4 | 5 | 90 | 5 | 0 | B4 | 8500 | 1.57 | 0.21 |
| Example 5 | 2 | 90 | 8 | 0 | B5 | 8000 | 1.64 | 0.21 |
| Example 6 | 4 | 91 | 5 | 0 | B6 | 8500 | 1.58 | 0.19 |
| □ BBP(bis(triethoxysilyl)biphenyl): bistriethoxybiphenyl | | | | | | | | |
| □ MT(methyltrimethoxysilane): methyltrimethoxysilane | | | | | | | | |
| □ PT(phenyltrimethoxysilane): phenyltrimethoxysilane | | | | | | | | |
| □ BE(bis(triethoxysilyl)ethane): bistriethoxysilylethane | | | | | | | | |

Referring to Table 1, the resist underlayers formed according to Comparative Examples 1 to 8 using a conventional organosilane condensation polymerization product have their refractive index increased as absorbance increases. Thus, it is impossible to have a low refractive index under the condition of a high absorbance. In short, it is confirmed that the absorbance and the refractive index are hardly modified.

However, referring to Table 2, the resist underlayers using the resist underlayer composition according to the embodiments of this disclosure make it possible to have a low refractive index under the condition of a high absorbance, and to have a high refractive index under the condition of a low absorbance condition. In one embodiment, the resist underlayer may have an absorbance of higher than 0.15 when it has a refractive index of lower than about 1.70 under the wavelength condition of lower than about 250 nm, in one embodiment, under the wavelength condition of 193 nm.

## Claims

1. A resist underlayer composition comprising:
(i) an organosilane condensation polymerization product obtained from at least one of the compounds of the Chemical Formula 1 and 2, and the compounds of the Chemical Formula 3 and 4, wherein the organosilane condensation polymerization product further includes a compound of the Chemical Formula 5; or
(ii) an organosilane condensation polymerization product including a repeating unit represented by the Chemical Formula 6; and
a solvent:
[Chemical Formula 1] [R¹]₃Si-[Ph¹]ₗ-Si[R²]₃
[Chemical Formula 2] [R¹]₃Si-[Ph¹]ₘ-Ph²
[Chemical Formula 3] [R¹]₃Si- (CH₂)ₙ-R³
[Chemical Formula 4] [R¹]₃Si-R⁴
[Chemical Formula 5] [R¹]₃Si-X-Si[R²]₃
[Chemical Formula 6] (SiO_{1.5}-[Ph¹]ₗ-SiO_{1.5})ₐ (Ph²-[Ph¹]ₘ-SiO_{1.5})_{b} (R³- (CH₂)ₙ-SiO_{1.5})_{c}(R⁴-SiO_{1.5})_{d}(SiO_{1.5}-X-SiO_{1.5})ₑ,
wherein 0≤a≤0.99, 0≤b≤0.99, 0.01≤a+b≤0.99, and 0≤c≤0.99, 0≤d≤0.99, 0<e≤0.99, 0.01≤c+d+e≤0.99, a+b+c+d+e=1;
wherein in the Chemical Formula 1 to 6,
Ph¹ is a substituted or unsubstituted phenylene group,
Ph² is a substituted or unsubstituted phenyl group,
R¹ and R² are the same or different, a halogen, a hydroxyl group, an alkoxy group, an ester group, a cyano group, a haloalkylsulfite group, an alkylamine group, an alkylsilylamine group, or an alkylsilyloxy group,
R³ is a substituted or unsubstituted C6 to C12 aryl group,
R⁴ is hydrogen or a C1 to C6 alkyl group,
X is a linear or branched substituted or unsubstituted alkylene group; or an alkylene group including an alkenylene group, or an urea group, in its main chain,
m is an integer ranging from 1 to 4,
1 is an integer ranging from 2 to 4, and
n is 0 or an integer ranging from 1 to 5.

2. The resist underlayer composition of claim 1, wherein the organosilane condensation polymerization product is produced under the presence of an acid catalyst or a base catalyst.

3. The resist underlayer composition of claim 1 or 2, wherein the organosilane condensation polymerization product has a weight average molecular weight of 2,000 to 50,000.

4. The resist underlayer composition of claims 1 to 3, wherein the organosilane condensation polymerization product is included in an amount ranging from 0.1 to 50 wt% based on total amount of the resist underlayer composition.

5. The resist underlayer composition of claims 1 to 4, further comprising a cross-linking agent, a radical stabilizer, a surfactant, or a combination thereof.

6. The resist underlayer composition of claims 1 to 5, further comprising a cross-linking catalyst of pyridinium p-toluenesulfonate, amidosulfobetain-16, ammonium(-)-camphor-10-sulfonic acid ammonium salt, ammonium formate, alkyltriethylammonium formate, pyridinium formate, tetrabutyl ammonium acetate, tetrabutyl ammonium azide, tetrabutyl ammonium benzoate, tetrabutyl ammonium bisulfate, tetrabutyl ammonium bromide, tetrabutyl ammonium chloride, tetrabutyl ammonium cyanide, tetrabutyl ammonium fluoride, tetrabutyl ammonium iodide, tetrabutyl ammonium sulfate, tetrabutyl ammonium nitrate, tetrabutyl ammonium nitrite, tetrabutyl ammonium p-toluene sulfonate, tetrabutyl ammonium phosphate, and a combination thereof.

7. A resist underlayer comprising an organosilane condensation polymerization product comprising a repeating unit represented by the Chemical Formula 6 according to claim 1.

8. A method of manufacturing semiconductor integrated circuit device, comprising:
(a) providing a material layer on a substrate;
(b) forming a first resist underlayer on the material layer;
(c) coating the resist underlayer composition of claim 1 on the first resist underlayer to form a second resist underlayer on the first resist underlayer;
(d) forming a radiation-sensitive imaging layer on the second underlayer;
(e) patternwise exposing the radiation-sensitive imaging layer to radiation to form a pattern of radiation-exposed regions in the imaging layer;
(f) selectively removing portions of the radiation-sensitive imaging layer and the second resist underlayer to expose portions of the first resist underlayer;
(g) selectively removing patterned second resist underlayer and portions of the first resist underlayer to expose portions of the material layer; and
(h) etching the exposed portions of the material layer to pattern the material layer.

9. The method of claim 8, further comprising forming an anti-reflection coating between the processes of forming the second resist underlayer (c) and forming a radiation-sensitive imaging layer.

10. The method of claim 8, wherein the second resist underlayer comprises an organosilane condensation polymerization product including a repeating unit represented by the following Chemical Formula 6:
[Chemical Formula 6] (SiO_{1.5}-[Ph¹]ₗ-SiO_{1.5})ₐ(Ph¹-[Ph¹]ₘ-SiO_{1.5})_{b}(R³-(CH₂)ₙ-SiO_{1.5})_{c}(R⁴-SiO_{1.5})_{d}(SiO_{1.5}-X-SiO_{1.5})ₑ
wherein in the above Chemical Formula 6,
Ph¹ is a substituted or unsubstituted phenylene group,
Ph² is a substituted or unsubstituted phenyl group,
R³ is a substituted or unsubstituted C6 to C12 aryl group,
R⁴ is hydrogen or a C1 to C6 alkyl group,
X is a linear or branched substituted or unsubstituted alkylene group; or an alkylene group including an alkenylene group, or an urea group, in its main chain,
m is an integer ranging from 1 to 4,
1 is an integer ranging from 2 to 4,
n is 0 or an integer ranging from 1 to 5, 0≤a≤0.99, 0≤b≤0.99, 0.01≤a+b≤0.99, and
0≤c≤0.99, 0≤d≤0.99, 0<e≤0.99, 0.01≤c+d+e≤0.99, a+b+c+d+e=1.

## Patentansprüche

1. Resistunterschichtzusammensetzung, mit:
(i) einem Organosilankondensationspolymerisationsprodukt das von mindestens einer der Verbindungen der chemischen Formeln 1 und 2 und der Verbindungen der chemischen Formeln 3 und 4 erhalten wird, wobei das Organosilankondensationspolymerisationsprodukt ferner eine Verbindung der chemischen Formel 5 aufweist;
oder
(ii) einem Organosilankondensationspolymerisationsprodukt mit einer durch die chemische Formel 6 dargestellten Wiederholungseinheit; und
einem Lösungsmittel:
[chemische Formel 1] [R¹]₃Si-[Ph¹]₁-Si[R²]₃
[chemische Formel 2] [R¹]₃Si-[Ph¹]ₘ-Ph²
[chemische Formel 3] [R¹]₃Si-(CH₂)ₙ-R³
[chemische Formel 4] [R¹]₃Si-R⁴
[chemische Formel 5] [R¹]₃Si-X-Si[R²]₃
[chemische Formel 6] (SiO_{1,5}-[Ph¹]ₗ-SiO_{1,5})ₐ(Ph²-[Ph¹]ₘ-SiO_{1,5})_{b}(R³-(CH₂)ₙ-SiO_{1,5})_{c}(R⁴-SiO_{1,5})_{d}(SiO_{1,5}-X-SiO_{1,5})ₑ
wobei 0 ≤ a ≤ 0,99, 0 ≤ b ≤ 0,99, 0,01 ≤ a+b ≤ 0,99, 0 ≤ c ≤ 0,99, 0 ≤ d ≤ 0,99, 0 < e ≤ 0,99, 0,01 ≤ c+d+e ≤ 0,99, und a+b+c+d+e = 1 ist;
wobei in den chemischen Formeln 1 bis 6:
Ph¹ eine substituierte oder unsubstituierte Phenylengruppe ist,
Ph² eine substituierte oder unsubstituierte Phenylgruppe ist,
R¹ und R² gleich oder verschieden und ein Halogen, eine Hydroxylgruppe, eine Alkoxygruppe, eine Estergruppe, eine Cyanogruppe, eine Haloalkylsulfitgruppe, eine Alkylamingruppe, eine Alkylsilylamingruppe oder eine Alkylsilyloxygruppe sind,
R³ eine substituierte oder unsubstituierte C6- bis C12-Arylgruppe ist,
R⁴ Wasserstoff oder eine C1- bis C6-Alkylgruppe ist,
X eine lineare oder verzweigte substituierte oder unsubstituierte Alkylengruppe oder eine Alkylengruppe mit einer Alkenylengruppe oder einer Ureagruppe in seiner Hauptkette ist,
m eine ganze Zahl von 1 bis 4 ist,
I eine ganze Zahl von 2 bis 4 ist, und
n = 0 oder eine ganze Zahl von 1 bis 5 ist.

2. Resistunterschichtzusammensetzung nach Anspruch 1, wobei das Organosilankondensationspolymerisationsprodukt bei Gegenwart eines Säurekatalysators oder eines Basenkatalysators erzeugt wird.

3. Resistunterschichtzusammensetzung nach Anspruch 1 oder 2, wobei das Organosilankondensationspolymerisationsprodukt ein gewichtsmittleres Molekulargewicht von 2000 bis 50000 aufweist.

4. Resistunterschichtzusammensetzung nach einem der Ansprüche 1 bis 3, wobei das Organosilankondensationspolymerisationsprodukt in einer Menge im Bereich von 0,1 bis etwa 50 Gew.-% bezogen auf das Gesamtgewicht der Resistunterschichtzusammensetzung enthalten ist.

5. Resistunterschichtzusammensetzung nach einem der Ansprüche 1 bis 4, ferner mit einem Vernetzungsmittel, einen Radikalstabilisator, einem Tensid oder einer Kombination davon.

6. Resistunterschichtzusammensetzung nach einem der Ansprüche 1 bis 5, ferner mit einem Vernetzungskatalysator aus Pyridinium-p-Toluolsulfonat, Amidosulfobetain-16, Ammonium(-)-Kampfer-10-Sulfonsäure-Ammoniumsalz, Ammoniumformiat, Alkyltriethylammoniumformiat, Pyridiniumformiat, Tetrabutylammoniumacetat, Tetrabutylammoniumazid, Tetrabutylammoniumbenzoat, Tetrabutylammoniumbisulfat, Tetrabutylammoniumbromid, Tetrabutylammoniumchlorid, Tetrabutylammoniumcyanid, Tetrabutylammoniumfluorid, Tetrabutylammoniumjodid, Tetrabutylammoniumsulfat, Tetrabutylammoniumnitrat, Tetrabutylammoniumnitrit, Tetrabutylammonium-p-toluolsulfonat, Tetrabutylammoniumphosphat oder einer Kombination davon.

7. Resistunterschicht mit einem Organosilankondensationspolymerisationsprodukt, das eine durch die chemische Formel 6 dargestellte Wiederholungseinheit gemäß Anspruch 1 aufweist.

8. Verfahren zum Herstellen eines integrierten Halbleiterschaltungselements, mit den Schritten
(a) Bereitstellen einer Materialschicht auf einem Substrat;
(b) Ausbilden einer ersten Resistunterschicht auf der Materialschicht;
(c) Aufbringen der Resistunterschichtzusammensetzung nach Anspruch 1 auf der ersten Resistunterschicht zum Ausbilden einer zweiten Resistunterschicht auf der ersten Resistunterschicht;
(d) Ausbilden einer strahlungsempfindlichen Abbildungsschicht auf der zweiten Resistunterschicht;
(e) Aussetzen der strahlungsempfindlichen Abbildungsschicht einer Strahlung in einem Muster zum Ausbilden eines Musters von durch Strahlung freigelegten Bereichen in der Abbildungsschicht;
(f) selektives Entfernen von Abschnitten der strahlungsempfindlichen Abbildungsschicht und der zweiten Resistunterschicht zum Freilegen von Abschnitten der ersten Resistunterschicht;
(g) selektives Entfernen der strukturierten zweiten Resistunterschicht und von Abschnitten der ersten Resistunterschicht zum Freilegen von Abschnitten der Materialschicht; und
(h) Ätzen der freigelegten Abschnitte der Materialschicht zum Strukturieren der Materialschicht.

9. Verfahren nach Anspruch 8, ferner mit dem Ausbilden einer Antireflexionsschicht zwischen dem Prozess zum Ausbilden der zweiten Unterschicht (c) und dem Ausbilden einer strahlungsempfindlichen Abbildungsschicht.

10. Verfahren nach Anspruch 8, wobei die zweite Resistunterschicht ein Organosilankondensationspolymerprodukt mit einer durch die folgende chemische Formel 6 dargestellten Wiederholungseinheit aufweist:
[chemische Formel 6] (SiO_{1,5}-[Ph¹]ₗ-SiO_{1,5})ₐ(Ph²-[Ph¹]ₘ-SiO_{1,5})_{b}(R³-(CH₂)ₙ-SiO_{1,5})_{c}(R⁴-SiO_{1,5})_{d}(SiO_{1,5}-X-SiO_{1,5})ₑ
wobei in der vorstehenden chemischen Formel 6:
Ph¹ eine substituierte oder unsubstituierte Phenylengruppe ist,
Ph² eine substituierte oder unsubstituierte Phenylgruppe ist,
R³ eine substituierte oder unsubstituierte C6- bis C12-Arylgruppe ist,
R⁴ Wasserstoff oder eine C1- bis C6-Alkylgruppe ist,
X eine lineare oder verzweigte substituierte oder unsubstituierte Alkylengruppe oder eine Alkylengruppe mit einer Alkenylengruppe oder einer Ureagruppe in seiner Hauptkette ist,
m eine ganze Zahl von 1 bis 4 ist,
I eine ganze Zahl von 2 bis 4 ist,
n =0 oder eine ganze Zahl von 1 bis 5 ist, und
0 ≤ a ≤ 0,99, 0 ≤ b ≤ 0,99, 0,01 ≤ a+b ≤ 0,99, 0 ≤ c ≤ 0,99, 0 ≤ d ≤ 0,99, 0 < e ≤ 0,99, 0,01 ≤ c+d+e ≤ 0,99, und a+b+c+d+e = 1 ist;

## Revendications

1. Composition de sous-couche de réserve comprenant :
(i) un produit de polymérisation par condensation d'organosilanes obtenu à partir d'au moins un des composés de la Formule Chimique 1 et 2, et des composés de la Formule Chimique 3 et 4, dans laquelle le produit de polymérisation par condensation d'organosilanes comprend en outre un composé de Formule Chimique 5 ;
ou
(ii) un produit de polymérisation par condensation d'organosilanes comprenant un motif répétitif représenté par la Formule Chimique 6 ; et
un solvant :
[Formule Chimique 1] [R¹]₃Si-[Ph¹]ₗ-Si [R²]₃
[Formule Chimique 2] [R¹]₃Si-[Ph¹]ₘ-Ph²
[Formule Chimique 3] [R¹]₃Si-(CH₂)ₙ-R³
[Formule Chimique 4] [R¹]₃Si-R⁴
[Formule Chimique 5] [R¹]₃Si-X-Si[R²]₃
[Formule Chimique 6] (SiO_{1,5}-[Ph¹]ₗ-SiO_{1,5})ₐ(Ph²-[Ph¹]ₘ-SiO_{1,5})_{b}(R³-(CH₂)ₙ-SiO_{1,5})_{c}(R⁴-SiO_{1,5})_{d}(SiO_{1,5}-X-SiO_{1,5})ₑ,
dans laquelle 0≤a≤0,99, 0≤b≤0,99, 0,01≤a+b≤0,99 et 0≤c≤0,99, 0≤d≤0,99, 0<e≤0,99, 0,01≤c+d+e≤0,99, a+b+c+d+e=1 ;
dans laquelle, dans la Formule Chimique 1 à 6,
Ph¹ est un groupe phénylène substitué ou non substitué,
Ph² est un groupe phényle substitué ou non substitué,
R¹ et R² sont identiques ou différents, un atome d'halogène, un groupe hydroxyle, un groupe alcoxy, un groupe ester, un groupe cyano, un groupe haloalkylsulfite, un groupe alkylamine, un groupe alkylsilylamine, ou un groupe alkylsilyloxy,
R³ est un groupe aryle substitué ou non substitué en C6 à C12,
R⁴ est un atome d'hydrogène ou un groupe alkyle en C1 à C6,
X est un groupe alkylène linéaire ou ramifié substitué ou non substitué ; ou un groupe alkylène comprenant un groupe alcénylène, ou un groupe urée, dans sa chaîne principale,
m est un nombre entier allant de 1 à 4,
l est un nombre entier allant de 2 à 4, et
n est égal à 0 ou un nombre entier allant de 1 à 5.

2. Composition de sous-couche de réserve selon la revendication 1, dans laquelle le produit de polymérisation par condensation d'organosilanes est produit en présence d'un catalyseur acide ou d'un catalyseur de base.

3. Composition de sous-couche de réserve selon la revendication 1 ou la revendication 2, dans laquelle le produit de polymérisation par condensation d'organosilanes a un poids moléculaire moyen en poids de 2000 à 50000.

4. Composition de sous-couche de réserve selon les revendications 1 à 3, dans laquelle le produit de polymérisation par condensation d'organosilanes est compris en une quantité allant de 0,1 à 50% en poids sur la base de la quantité totale de la composition de sous-couche de réserve.

5. Composition de sous-couche de réserve selon les revendications 1 à 4, comprenant en outre un agent de réticulation, un stabilisateur de radical, un tensio-actif, ou une combinaison de ceux-ci.

6. Composition de sous-couche de réserve selon les revendications 1 à 5, comprenant en outre un catalyseur de réticulation de pyridinium p-toluènesulfonate, amidosulfobetain-16, ammonium de (-)-camphre-1 0-sulfonique, sel d'acide d'ammonium, formiate d'ammonium, formiate d'alkyltriéthylammonium, formiate de pyridinium, acétate de tétrabutylammonium, azoture de tétrabutylammonium, benzoate de tétrabutylammonium, hydrogénosulfate de tétrabutylammonium, bromure de tétrabutylammonium, chlorure de tétrabutylammonium, cyanure de tétrabutylammonium, fluorure de tétrabutylammonium, iodure de tétrabutylammonium, sulfate de tétrabutylammonium, nitrate de tétrabutylammonium, nitrite de tétrabutylammonium, p-toluène-sulfonate de tétrabutylammonium, phosphate de tétrabutylammonium, et une combinaison de ceux-ci.

7. Sous-couche de réserve comprenant un produit de polymérisation par condensation d'organosilanes comprenant un motif répétitif représenté par la Formule Chimique 6 selon la revendication 1.

8. Procédé de fabrication d'un dispositif de circuit intégré à semi-conducteur, comprenant :
(a) fournir une couche de matériau sur un substrat ;
(b) former une première sous-couche de réserve sur la couche de matériau ;
(c) revêtir la composition de sous-couche de réserve selon la revendication 1 sur la première sous-couche de réserve pour former une deuxième sous-couche de réserve sur la première sous-couche de réserve ;
(d) former une couche formatrice d'image sensible au rayonnement sur la deuxième sous-couche ;
(e) exposer sous forme de motif la couche formatrice d'image sensible au rayonnement à un rayonnement pour former un motif de zones exposées aux rayonnements dans la couche formatrice d'image ;
(f) retirer sélectivement des parties de la couche formatrice d'image sensible au rayonnement et la deuxième sous-couche de réserve pour exposer des parties de la première sous-couche de réserve ;
(g) retirer sélectivement la deuxième sous-couche de réserve à motif et des parties de la première sous-couche de réserve pour exposer des parties de la couche de matériau ; et
(h) graver les parties exposées de la couche de matériau pour former un motif sur la couche de matériau.

9. Procédé selon la revendication 8, comprenant en outre la formation d'un revêtement anti-reflets entre les procédés de formation de la deuxième sous-couche de réserve (c) et de formation d'une couche formatrice d'image sensible au rayonnement.

10. Procédé selon la revendication 8, dans lequel la deuxième sous-couche de réserve comprend un produit de polymérisation par condensation d'organosilanes comprenant un motif répétitif représenté par la Formule Chimique 6 suivante :
[Formule Chimique 6] (SiO_{1,5}-[Ph¹]ₗ-SiO_{1,5})ₐ(Ph²-[Ph¹]ₘ-SiO_{1,5})_{b}(R³-(CH₂)ₙ-SiO_{1,5})_{c}(R⁴-SiO_{1,5})_{d}(SiO_{1,5}-X-SiO_{1,5})ₑ,
dans lequel, dans la Formule Chimique 6 ci-dessus,
Ph¹ est un groupe phénylène substitué ou non substitué,
Ph² est un groupe phényle substitué ou non substitué,
R³ est un groupe aryle substitué ou non substitué en C6 à C12,
R⁴ est un atome d'hydrogène ou un groupe alkyle en C1 à C6,
X est un groupe alkylène linéaire ou ramifié substitué ou non substitué ; ou un groupe alkylène comprenant un groupe alcénylène, ou un groupe urée, dans sa chaîne principale,
m est un nombre entier allant de 1 à 4,
l est un nombre entier allant de 2 à 4,
n est égal à 0 ou un nombre entier allant de 1 à 5,
0≤a≤0,99, 0≤b≤0,99, 0,01≤a+b≤0,99, et
0≤c≤0,99, 0≤d≤0,99, 0<e≤0,99, 0,01≤c+d+e≤0,99, a+b+c+d+e=1.
